# EUROPEAN PATENT SPECIFICATION

(11) **EP 4 341 932 B1**
(45) Date of publication and mention of the grant of the patent: **21.10.2026**
(21) Application number: 22747888.0
(22) Date of filing: 05.07.2022
(51) Int. Cl.: G10L 19/00, G10L 25/30, H03M 7/30

(54) **COMPRESSING AUDIO WAVEFORMS USING NEURAL NETWORKS AND VECTOR QUANTIZERS**
KOMPRIMIERUNG VON AUDIOWELLENFORMEN UNTER VERWENDUNG NEURONALER NETZWERKE UND VEKTORQUANTISIERERN
COMPRESSION DE FORMES D'ONDE AUDIO À L'AIDE DE RÉSEAUX NEURONAUX ET DE QUANTIFICATEURS VECTORIELS

(30) Priority: 02.07.2021 US 202163218139 P; 01.07.2022 US 202217856856
(43) Date of publication of application: 27.03.2024
(60) Divisional application: 24190155.2 / 4 425 493
(73) Proprietor: Google LLC, Mountain View, CA 94043 (US)
(72) Inventor: ZEGHIDOUR, Neil, 75009 Paris (FR); TAGLIASACCHI, Marco, 8002 Zurich (CH); ROBLEK, Dominik, 8002 Zürich (CH)
(74) Representative: Varley, James Richard
(86) International application number: PCT/US2022/036097
(87) International publication number: WO 2023/278889

(56) References cited:
- US-A- 5 966 688
- US-A1- 2020 234 725
- JONAH CASEBEER ET AL: "Enhancing into the codec: Noise Robust Speech Coding with Vector-Quantized Autoencoders", ARXIV.ORG, CORNELL UNIVERSITY LIBRARY, 201 OLIN LIBRARY CORNELL UNIVERSITY ITHACA, NY 14853, 12 February 2021 (2021-02-12), XP081884643
- CHRISTOPHER F BARNES ET AL: "Advances in Residual Vector Quantization: A Review", IEEE TRANSACTIONS ON IMAGE PROCESSING, IEEE, USA, vol. 5, no. 2, 1 February 1996 (1996-02-01), pages 226 - 262, XP011025938, ISSN: 1057-7149, DOI: 10.1109/83.480761

## Description

### BACKGROUND

This specification relates to processing data using machine learning models.

Machine learning models receive an input and generate an output, e.g., a predicted output, based on the received input. Some machine learning models are parametric models and generate the output based on the received input and on values of the parameters of the model.

Some machine learning models are deep models that employ multiple layers of models to generate an output for a received input. For example, a deep neural network is a deep machine learning model that includes an output layer and one or more hidden layers that each apply a non-linear transformation to a received input to generate an output.

US 2020/234725 A1 discloses methods, systems, and apparatus, including computer programs encoded on computer storage media, for generating discrete latent representations of input audio data. Only the discrete latent representation needs to be transmitted from an encoder system to a decoder system in order for the decoder system to be able to effectively to decode, i.e., reconstruct, the input audio data.

"Enhancing into the codec: Noise Robust Speech Coding with Vector-Quantized Autoencoders" (J. Casebeer et al., arXiv:2102.06610 v1) discloses compressor-enhancer encoders and accompanying decoders based on VQ-VAE autoencoders with WaveRNN decoders.

### SUMMARY

The invention is defined in the appended claims.

This specification generally describes a compression system implemented as computer programs on one or more computers in one or more locations that can compress audio waveforms. The specification further describes a decompression system implemented as computer programs on one or more computers in one or more locations that can decompress audio waveforms.

Generally, the compression system and the decompression system can be located in any appropriate locations. In particular, the compression system can optionally be located remotely from the decompression system. For example, the compression system can be implemented by one or more first computers at a first location, while the decompression system can be implemented by one or more second (different) computers at a second (different) location.

In some implementations, the compression system can generate a compressed representation of an input audio waveform and store the compressed representation in a data store, e.g., a logical data storage area or a physical data storage device. The decompression system can later access the compressed representation from the data store, and process the compressed representation to generate a corresponding output audio waveform. The output audio waveform can be, e.g., a reconstruction of the input audio waveform or an enhanced (e.g., de-noised) version of the input audio waveform.

In some implementations, the compression system can generate a compressed representation of an input audio waveform and transmit the compressed representation to a destination over a data communication network, e.g., a local area network, a wide area network, or the internet. The decompression system can access the compressed representation at the destination, and process the compressed representation to generate a corresponding output waveform.

According to a first aspect, there is provided a method performed by one or more computers, the method comprising: receiving an audio waveform that comprises a respective audio sample for each of a plurality of time steps; processing the audio waveform using an encoder neural network to generate a plurality of feature vectors representing the audio waveform; generating a respective coded representation of each of the plurality of feature vectors using a plurality of vector quantizers that are each associated with a respective codebook of code vectors, wherein the respective coded representation of each feature vector identifies a plurality of code vectors, including a respective code vector from the codebook of each vector quantizer, that define a quantized representation of the feature vector; and generating a compressed representation of the audio waveform by compressing the respective coded representation of each of the plurality of feature vectors.

According to the invention, the plurality of vector quantizers are ordered in a sequence, and wherein for each of the plurality of feature vectors, generating the coded representation of the feature vector comprises: for a first vector quantizer in the sequence of vector quantizers: receiving the feature vector; identifying, based on the feature vector, a respective code vector from the codebook of the vector quantizer to represent the feature vector; and determining a current residual vector based on an error between: (i) the feature vector, and (ii) the code vector that represents the feature vector; wherein the coded representation of the feature vector identifies the code vector that represents the feature vector.

According to the invention, for each of the plurality of feature vectors, generating the coded representation of the feature vector further comprises: for each vector quantizer after the first vector quantizer in the sequence of vector quantizers: receiving a current residual vector generated by a preceding vector quantizer in the sequence of vector quantizers; identifying, based on the current residual vector, a respective code vector from the codebook of the vector quantizer to represent the current residual vector; and if the vector quantizer is not a last vector quantizer in the sequence of vector quantizers: updating the current residual vector based on an error between: (i) the current residual vector, and (ii) the code vector that represents the current residual vector; wherein the coded representation of the feature vector identifies the code vector that represents the current residual vector.

In some implementations, generating the compressed representation of the audio waveform comprises: entropy encoding the respective coded representation of each of the plurality of feature vectors.

In some implementations, the respective quantized representation of each feature vector is defined by a sum of the plurality of code vectors identified by the coded representation of the feature vector.

In some implementations, the codebooks of the plurality of vector quantizers all include an equal number of code vectors.

According to the invention, the encoder neural network and the codebooks of the plurality of vector quantizers are jointly trained along with a decoder neural network, wherein the decoder neural network is configured to: receive a respective quantized representation of each of a plurality of feature vectors representing an input audio waveform that are generated using the encoder neural network and the plurality of vector quantizers; and process the quantized representations of the feature vectors representing the input audio waveform to generate an output audio waveform.

In some implementations, the training comprises: obtaining a plurality of training examples that each include: (i) a respective input audio waveform, and (ii) a corresponding target audio waveform; processing the respective input audio waveform from each training example using the encoder neural network, a plurality of vector quantizers from a sequence of vector quantizers, and the decoder neural network to generate an output audio waveform that is an estimate of the corresponding target audio waveform; determining gradients of an objective function that depends on the respective output and target waveforms for each training example; and using the gradients of the objective function to update one or more of: a set of encoder neural network parameters, a set of decoder neural network parameters, or the codebooks of the plurality of vector quantizers.

In some implementations, for one or more of the training examples, the target audio waveform is an enhanced version of the input audio waveform.

In some implementations, for one or more of the training examples, the target audio waveform is a de-noised version of the input audio waveform.

**In** some implementations, for one or more of the training examples, the target audio waveform is the same as the input audio waveform.

In some implementations, processing each input audio waveform to generate the corresponding output audio waveform comprises: conditioning the encoder neural network, the decoder neural network, or both, on data that defines whether the corresponding target audio waveform is: (i) the input audio waveform or (ii) an enhanced version of the input audio waveform.

In some implementations, the method further comprises, for each training example: selecting a respective number of vector quantizers to be used in quantizing feature vectors representing the input audio waveform; generating the corresponding output audio waveform using only the selected number of vector quantizers from the sequence of vector quantizers.

In some implementations, the selected number of vector quantizers to be used in quantizing feature vectors representing input audio waveforms varies between training examples.

In some implementations, for each training example, selecting the respective number of vector quantizers to be used in quantizing feature vectors representing the input audio waveform comprises: randomly sampling the number of vector quantizers to be used in quantizing feature vectors representing the input audio waveform.

In some implementations, the objective function comprises a reconstruction loss that, for each training example, measures an error between: (i) the output audio waveform, and (ii) the corresponding target audio waveform.

In some implementations, for each training example, the reconstruction loss measures a multi-scale spectral error between: (i) the output audio waveform, and (ii) the corresponding target audio waveform.

In some implementations, the training further comprises, for each training example: processing data derived from the output audio waveform using a discriminator neural network to generate a set of one or more discriminator scores, wherein each discriminator score characterizes an estimated likelihood that the output audio waveform is an audio waveform that was generated using the encoder neural network, the plurality of vector quantizers, and the decoder neural network; wherein the objective function comprises an adversarial loss that depends on the discriminator scores generated by the discriminator neural network.

In some implementations, the data derived from the output audio waveform comprises the output audio waveform, a down-sampled version of the output audio waveform, or a Fourier-transformed version of the output audio waveform.

**In** some implementations, for each training example, the reconstruction loss measures an error between: (i) one or more intermediate outputs generated by the discriminator neural network by processing the output audio waveform, and (ii) one or more intermediate outputs generated by the discriminator neural network by processing the corresponding target audio waveform.

**In** some implementations, the codebooks of the plurality of vector quantizers are repeatedly updated during the training using exponential moving averages of feature vectors generated by the encoder neural network.

**In** some implementations, the encoder neural network comprises a sequence of encoder blocks that are each configured to process a respective set of input feature vectors in accordance with a set of encoder block parameters to generate a set of output feature vectors having a lower temporal resolution than the set of input feature vectors.

**In** some implementations, the decoder neural network comprises a sequence of decoder blocks that are each configured to process a respective set of input feature vectors in accordance with a set of decoder block parameters to generate a set of output feature vectors having a higher temporal resolution than the set of input feature vectors.

**In** some implementations, the audio waveform is a speech waveform or a music waveform.

**In** some implementations, the method further comprises transmitting the compressed representation of the audio waveform across a network.

According to another aspect, there is provided a method performed by one or more computers, the method comprising: receiving a compressed representation of an input audio waveform; decompressing the compressed representation of the input audio waveform to obtain a respective coded representation of each of a plurality of feature vectors representing the input audio waveform, wherein the coded representation of each feature vector identifies a plurality of code vectors, including a respective code vector from a respective codebook of each of a plurality of vector quantizers, that define a quantized representation of the feature vector; generating a respective quantized representation of each feature vector from the coded representation of the feature vector; and processing the quantized representations of the feature vectors using a decoder neural network to generate an output audio waveform.

According to another aspect, there is provided a system comprising: one or more computers; and one or more storage devices communicatively coupled to the one or more computers, wherein the one or more storage devices store instructions that, when executed by the one or more computers, cause the one or more computers to perform operations of the respective methods described herein.

According to another aspect, there are provided one or more non-transitory computer storage media storing instructions that when executed by one or more computers cause the one or more computers to perform operations of the respective methods described herein.

The subject matter described in this specification can be implemented in particular embodiments so as to realize one or more of the following advantages.

The compression/decompression systems described in this specification can enable audio data to be compressed more efficiently than some conventional systems. By enabling more efficient audio data compression, the systems allow more efficient audio data transmission (e.g., by reducing the communication network bandwidth required to transmit audio data) and more efficient audio data storage (e.g., by reducing the amount of memory required to store audio data).

The compression/decompression systems include an encoder neural network, a set of vector quantizers, and a decoder neural network that are jointly trained (i.e., from "end-to-end"). Jointly training the respective neural network parameters of the encoder and decoder neural networks along with the codebooks of the vector quantizers enables the parameters of the compression/decompression systems to be adapted in unison to achieve more efficient audio compression than would otherwise be possible. For example, as the neural network parameters of the encoder neural network are iteratively adjusted, the codebooks of the vector quantizers are simultaneously optimized to enable more accurate quantization of the feature vectors generated by the encoder neural network. The neural network parameters of the decoder neural network are also simultaneously optimized to enable more accurate reconstruction of audio waveforms from quantized feature vectors generated using the updated codebooks of the vector quantizers.

Performing vector quantization of feature vectors representing audio waveforms using a single vector quantizer, where each feature vector is represented using r bits, can require a codebook of size 2*^{r}*. That is, the size of the codebook of the vector quantizer can increase exponentially with the number of bits allocated to represent each feature vector. As the number of bits allocated to represent each feature vector increases, leaming and storing the codebook becomes computationally infeasible. To address this issue, the compression/decompression systems perform vector quantization using a sequence of multiple vector quantizers that each maintain a respective codebook. The first vector quantizer can directly quantize feature vectors generated by the encoder neural network, while each subsequent vector quantizer can quantize residual vectors that define the quantization error generated by the preceding vector quantizer.

The sequence of vector quantizers can iteratively refine the quantization of feature vectors while each maintaining a dramatically smaller codebook that would be required by a single vector quantizer. For example, each vector quantizer can maintain a codebook of size ${2}^{\frac{r}{{N}_{q}}}$ where *r* is the number of bits allocated to represent each feature vector and *N_{q}* is the number of vector quantizers. Performing vector quantization using a sequence of multiple vector quantizers thus enables the compression/decompression system to reduce the memory required to store the quantizer codebooks and allows vector quantization to be performed in situations in which doing so would otherwise be computationally infeasible.

Performing vector quantization using a set of multiple vector quantizers (i.e., rather than a single vector quantizer) also enables the compression/decompression systems to control the compression bitrate, e.g., the number of bits used to represent each second of audio data. To reduce the bitrate, the compression/decompression systems can perform vector quantization using fewer vector quantizers. Conversely, to increase the bitrate, the compression/decompression systems can perform vector quantization using more vector quantizers. During training, the number of vector quantizers used for compression/decompression of each audio waveform can be varied (e.g., randomly) across training examples, causing the compression/decompression systems to learn a single set of parameter values that enable effective compression/decompression across a range of possible bitrates. Thus the compression/decompression systems enable reduced consumption of computational resources by obviating any requirement to train and maintain multiple respective encoders, decoders, and vector quantizers that are each optimized for a respective bitrate.

The compression/decompression systems can be trained to jointly perform both audio data compression and audio data enhancement, e.g., de-noising. That is, the compression and decompression systems can be trained to simultaneously enhance (e.g., de-noise) an audio waveform as part of compressing and decompressing the waveform without increasing overall latency. In contrast, some conventional systems apply a separate audio enhancement algorithm to an audio waveform at the transmitter side (i.e., before compression) or at the receiver side (i.e., after decompression) which can result in increased latency.

The details of one or more embodiments of the subject matter of this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 depicts an example audio compression system that can compress audio waveforms using an encoder neural network and a residual vector quantizer.
FIG. 2 depicts an example audio decompression system that can decompress compressed audio waveforms using a decoder neural network and a residual vector quantizer.
FIG. 3 is a schematic diagram of an example training system that can jointly train an encoder neural network, a decoder neural network and a residual vector quantizer.
FIG. 4 is a flow diagram of an example process for compressing an audio waveform.
FIG. 5 is a flow diagram of an example process for decompressing a compressed audio waveform.
FIG. 6 is a flow diagram of an example process for generating quantized representations of feature vectors using a residual vector quantizer.
FIG. 7 is a flow diagram of an example process for jointly training an encoder neural network, a decoder neural network and a residual vector quantizer.
FIGS. 8A and 8B show an example of a fully convolutional neural network architecture.

Like reference numbers and designations in the various drawings indicate like elements.

### DETAILED DESCRIPTION

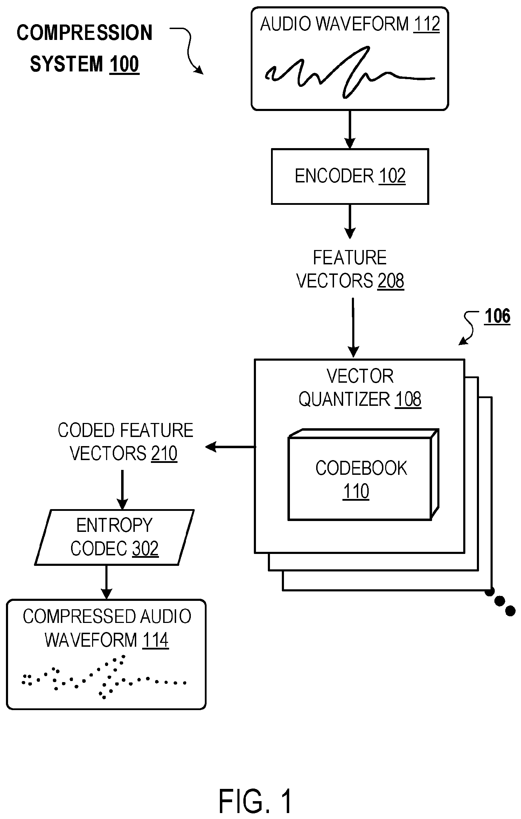

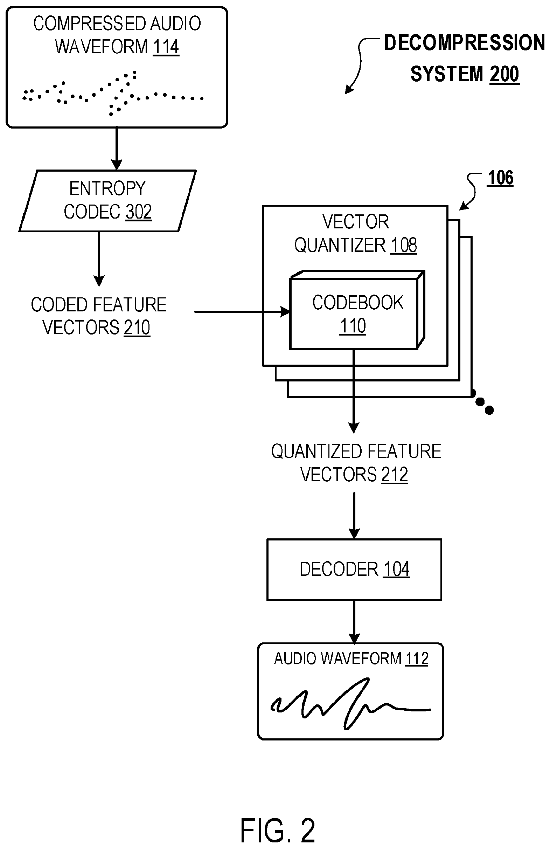

FIG. 1 depicts an example audio compression system 100 that can compress audio waveforms using an encoder neural network 102 and a residual vector quantizer 106. Similarly, FIG. 2 depicts an example audio decompression system 200 that can decompress compressed audio waveforms using a decoder neural network 104 and the residual vector quantizer 106. For clarity, reference will be made to both FIG. 1 and FIG. 2 when describing various components involved in compression and decompression. The audio compression/decompression systems 100/200 are examples of systems implemented as computer programs on one or more computers in one or more locations in which the systems, components, and techniques described below are implemented.

The compression/decompression systems 100/200 utilize a neural network architecture (neural codec) that can outperform traditional codecs, e.g., waveform and parametric codecs, in terms of operational bitrates and general-purpose audio compression. For comparison, waveform codecs typically use time/frequency domain transforms for compression/decompression while making little or no assumptions about the source audio. As a consequence of this, they produce high-quality audio at mid-to-high level bitrates but tend to introduce coding artifacts at low bitrates. Parametric codecs can overcome this problem by making specific assumptions about the source audio (e.g., speech) but are ineffective for general-purpose audio compression. Conversely, the audio compression and decompression systems 100/200 can compress and decompress speech, music and general audio at bitrates normally targeted by speech-tailored codecs (e.g., parametric codecs). Hence, the audio compression/decompression systems 100/200 can operate in modalities that conventional codecs are incapable of. In some implementations, the compression and decompression systems 100/200 can be configured for specific types of audio content (e.g., speech) due to the flexibility admitted by the neural network architecture.

Referring to FIG. 1, the compression system 100 receives an audio waveform 112 to be compressed. The waveform 112 can include an audio sample at each time step, where the time step usually corresponds to a particular sampling rate. Higher sampling rates capture higher frequency components of the audio waveform 112. For example, the standard audio sampling rate used by professional digital equipment is 48 kHz since it can reconstruct sound at frequencies up to 24 kHz (e.g., upper limit of human hearing). Although such sampling rates are ideal for comfortable listening, the compression system 100 can generally be configured to process waveforms 112 at any sampling rate, even waveforms with non-uniform sampling.

The audio waveform 112 can originate from any suitable audio source. For example, the waveform 112 can be a recording from an external audio device (e.g., speech from a microphone), a purely digital production (e.g., electronic music), or generic audio such as sound effects and background noise (e.g., white noise, room tone). In some implementations, the audio compression system 100 can perform audio enhancement, e.g., suppressing unwanted background noise, simultaneously when compressing the waveform 112.

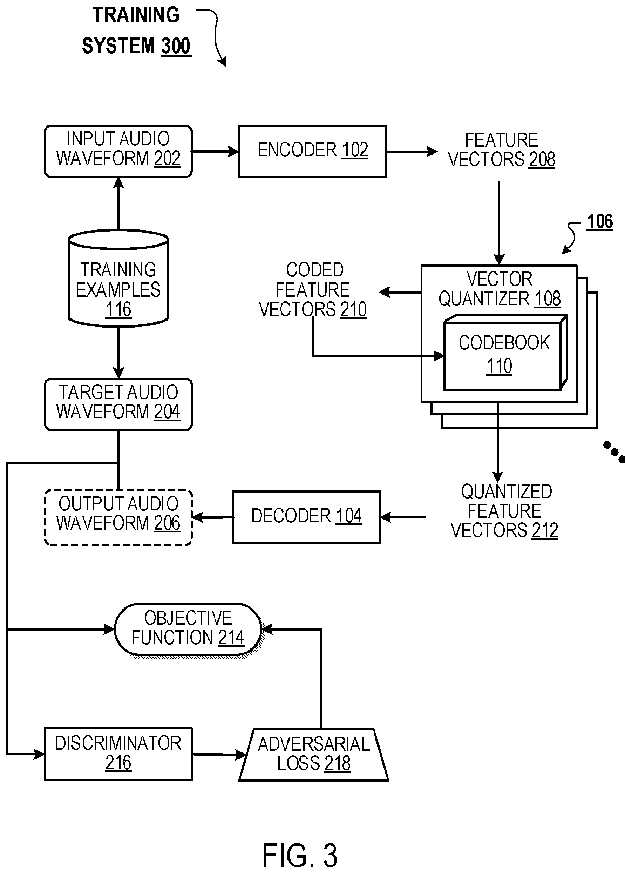

In conventional audio processing pipelines, compression and enhancement are usually performed by separate modules. For example, it is possible to apply an audio enhancement algorithm at the input of the encoder 102, before a waveform is compressed, or at the output of the decoder 104, after the waveform is decompressed. In this setup, each processing step contributes to the end-to-end latency, e.g., due to buffering the waveform to an expected frame length of the algorithm. Conversely, utilizing judicious training of various neural network components (see FIG. 3), the audio compression system 100 can accomplish joint compression and enhancement without relying on a separate module and incurring no additional latency. In some implementations, the audio decompression system 200 implements joint decompression and enhancement. In general, the compression system 100, decompression system 200, or both can be designed to perform audio enhancement by adequately training the neural network components.

The audio waveform 112 is processed (e.g., encoded) by the encoder 102 to generate a sequence of feature vectors 208 representing the waveform 112. Feature vectors 208 (e.g., embeddings, latent representations) are compressed representations of waveforms that extract the most relevant information about their audio content. The encoder 102 can down-sample the input waveform 202 to generate the compressed feature vectors 208, such that the feature vectors 208 have a lower sampling rate than the original audio waveform 112. For example, the encoder neural network 102 can use multiple convolutional layers with increasing strides to generate feature vectors 208 at the lower sampling rate (e.g., lower temporal resolution).

The feature vectors 208 are then processed by a residual (e.g., multi-stage) vector quantizer RVQ 106 to generate coded representations of the feature vectors (CFVs) 210 and corresponding quantized representations of the feature vectors (QFVs) 212. The RVQ 106 can generate QFVs 212 at a particular bitrate by leveraging one or more vector quantizers 108. The RVQ 108 realizes (lossy) compression by mapping the higher-dimensional space of feature vectors 208 to a discrete subspace of code vectors. As will be elaborated below, a CFV 210 specifies codewords (e.g., indices) from respective codebooks 110 of each vector quantizer 108, where each codeword identifies a code vector stored in the associated codebook 110. Consequently, a QFV 212 is an approximation of a feature vector 208 defined by the combination of code vectors specified by the corresponding CFV 212. Generally, the QFV 212 is a summation (e.g., linear combination) of code vectors specified by the CFV 212.

In some cases not being part of the present invention, the RVQ 106 uses a single vector quantizer 108 with a single codebook 110. The quantizer 108 can compress a feature vector 208 into a QFV 212 by choosing a code vector in its codebook 110 to represent the feature vector 208. The quantizer 106 can select the code vector based on any appropriate distance metric (e.g., error) between the two vectors, e.g., *Lⁿ*-norm, cosine distance, etc. For example, the RVQ 106 can select the code vector with the smallest Euclidean norm (e.g., *L²*-norm) relative to the feature vector 208. The quantizer 106 can then store the corresponding codeword in a CFV 210. Since codewords generally require fewer bits than code vectors, CFVs 210 consume less space in memory and can achieve greater compression than QFVs 212 with no additional loss.

Nevertheless, a single vector quantizer 108 approach can become prohibitively expensive, as the size of the codebook 110 grows exponentially as the bitrate is increased. To overcome this problem, the RVQ 106 utilizes a sequence of vector quantizers 108. In this case, each vector quantizer 108 in the sequence contains a respective codebook 110 of code vectors. The RVQ 106 can then use an iterative method to generate the CFVs 210 and corresponding QFVs 212, such that each vector quantizer 108 in the sequence further refines quantization.

For example, at the first vector quantizer 108, the quantizer 106 can receive the feature vector 208 and select a code vector from its codebook 110 to represent the feature vector 208 based on a smallest distance metric. A residual vector can be computed as the difference between the feature vector 208 and the code vector representing the feature vector 208. The residual vector can be received by the next quantizer 108 in the sequence to select a code vector from its codebook 110 to represent the residual vector based on a smallest distance metric. The difference between these two vectors can be used as the residual vector for the next iteration. This iterative method can continue for each vector quantizer 108 in the sequence. Every code vector identified in the method can be summed into the QFV 212 and the codeword of each code vector can be stored in a respective CFV 210.

In general, the RVQ 106 can utilize any suitable number of vector quantizers 108. The number of quantizers *N_{q}* and the size of each codebook *Nᵢ* control tradeoffs between computational complexity and coding efficiency. Hence, a sequence of quantizers 108 provides a flexible means of balancing these two opposing factors. In some cases, the size of each codebook *Nᵢ* = *N* is identical such that the total bit budget is allocated uniformly across each vector quantizer 108. A uniform allocation provides a practical modularity to the RVQ 106 as each codebook 110 consumes the same space in memory.

Moreover, for fixed size codebooks *Nᵢ,* the number of vector quantizers *N_{q}* in the sequence determines the resulting bitrate of the QFVs 212, where higher bitrates correspond to a larger number of quantizers 108. Thus, the RVQ 106 offers a convenient framework for variable (e.g., scalable) bitrates by employing a structured dropout of quantizers 108. That is, the audio compression and decompression systems 100/200 can vary the number of quantizers 108 in the sequence to target any desired bitrate, facilitating adjustable performance and reducing overall memory footprint compared with multiple fixed bitrate codecs. Due to these capabilities, the compression/decompression systems 100/200 can be particularly amendable to low latency implementations, apt for devices with limited computing resources (e.g., smartphones, tablets, watches, etc.).

The CFVs 218 can then be further compressed, for example using an entropy codec 302, into a compressed representation of the audio waveform 114. The entropy codec 302 can implement any appropriate lossless entropy coding, e.g., arithmetic coding, Huffman coding, etc.

Referring to FIG. 2, the decompression system 200 receives a compressed representation of an audio waveform 114. In general, the compressed audio waveform 114 can represent any type of audio content, e.g., speech, music, general audio, etc. Granted, as mentioned previously, the audio compression and decompression systems 100/200 can be implemented for specific tasks (e.g., speech-tailored compression/decompression) to optimize around specific types of audio content.

The compressed audio waveform 114 can be decompressed into CFVs 210, for example using the entropy codec 302. The CFVs 210 are then processed by the RVQ 106 into QFVs 212. As described above, each CFV 210 includes codewords (e.g., indices) that identify code vectors in respective codebooks 110 of each vector quantizer 108. The combination of code vectors specified by each CFV 210 identifies the corresponding QFV 212. Generally, the code vectors identified by each CFV 210 are summed into the corresponding QFV 212.

The QFVs 212 can then be processed (e.g., decoded) by the decoder 104 to generate an audio waveform 112. The decoder 104 generally mirrors the processes of the encoder 102 by outputting waveforms starting from (quantized) feature vectors. The decoder 104 can up-sample the QFVs 212 to generate the output waveform 206 at a higher sampling rate than the input QFVs 212. For example, the decoder 102 can use multiple convolutional layers with decreasing strides to generate the output waveform 206 at the higher sampling rate (e.g., higher temporal resolution).

Note that the compression/decompression systems 100/200 can be realized in various different implementations such as being integrated as a single system or as separate systems. Moreover, components of each of the compression/decompression systems 100/200 need not be constrained to a single client device. For example, in some implementations, the compression system 100 stores the compressed audio waveform 114 in local storage which is then retrieved from local storage by the decompression system 200. In other implementations, the compression system 100 on a transmitter client transmits the compressed audio waveform 114 across a network (e.g., internet, 5G cellular network, Bluetooth, Wi-Fi, etc.) which can be received by the decompression system 200 on a receiver client.

As will be described in more detail below, the neural network architecture can be trained using a training system 300. The training system 300 can enable efficient general-purpose compression or tailored compression (e.g., speech-tailored) by utilizing a suitable set of training examples 116 and various training procedures. Specifically, the training system 300 can jointly train the encoder neural network 102 and decoder neural network 104 to efficiently encode and decode feature vectors 208 of various waveforms contained in the training examples 116. Furthermore, the training system 300 can train the RVQ 106 to efficiently quantize the feature vectors 208. In particular, each codebook 110 of each cascading vector quantizer 108 can be trained to minimize quantization error. To facilitate trainable codebooks 110, each vector quantizer 108 can, for example, be realized as a vector quantized variational autoencoder (VQ-VAE).

The audio compression/decompression systems 100/200 can be a fully "end-to-end" machine learning approach when implementing this data-driven training solution. In the end-to-end implementation, the compression/decompression systems 100/200 leverage the neural networks for all tasks involved in training, as well as inference after training. No processing, such as feature extraction, is performed by an external system. In general, the training system 300 can utilize unsupervised learning algorithms, semi-supervised learning algorithms, supervised learning algorithms, or more elaborate combinations of these. For example, the training system 300 can balance reconstruction losses with adversarial losses to enable audio compression that is both faithful and perceptually similar to the original audio on playback.

Generally, the neural networks included in the audio compression/decompression systems 100/200 can have any appropriate neural network architectures which enable them to perform their described functions. In particular, the neural networks can each include any appropriate neural network layers (e.g., fully-connected layer, convolutional layers, attention layers, etc.) in any appropriate numbers (e.g., 5, 10, or 100 layers) and arranged in any appropriate configuration (e.g., as a linear sequence of layers).

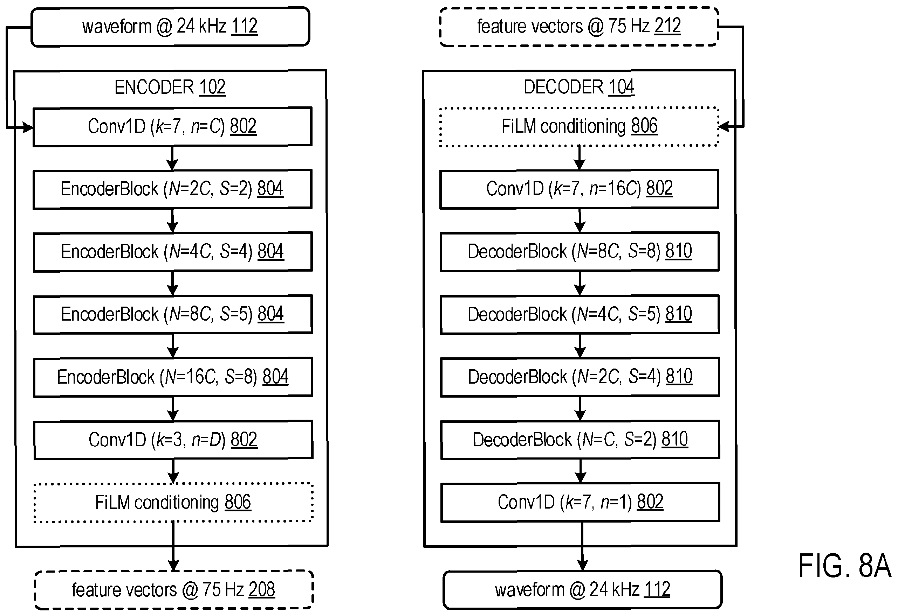

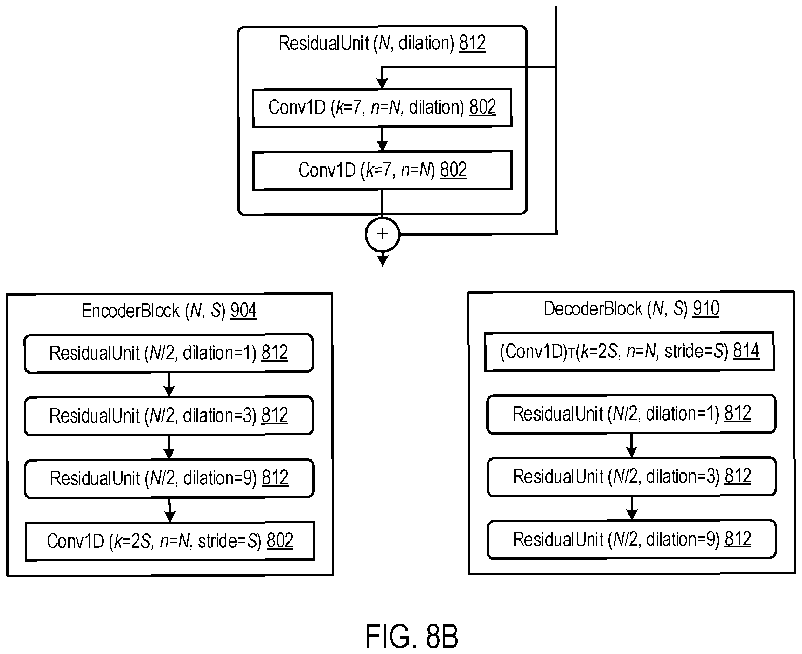

In some implementations, the compression/decompression systems 100/200 exploit a fully convolutional neural network architecture. FIGS. 8A and 8B show an example implementation of such an architecture for the encoder 102 and decoder 104 neural networks. A fully convolutional architecture can be particularly advantageous for low latency compression since it has a lower scale connectivity compared to fully-connected networks (e.g., multilayer perceptrons) and has filters (e.g., kernels) that can be optimized to limit coding artifacts. Moreover, convolutional neural networks provide an effective means of resampling the waveform 112, i.e., changing the temporal resolution of the waveform 112, by using different strides for different convolutional layers.

In further implementations, the compression/decompression systems 100/200 use strictly causal convolutions when implementing a fully convolutional architecture, such that padding is only applied to the past but not the future in both training and offline inference. No padding is necessary for streaming inference. In this case, the overall latency of the compression and decompressions systems 100/200 is determined entirely by the temporal resampling ratio between waveforms and their corresponding feature vectors.

FIG. 3 shows operations performed by an example training system 300 to jointly train an encoder neural network 102, a decoder neural network 104 and a residual vector quantizer 106. The neural networks are trained end-to-end on an objective function 214 that can include numerous reconstruction losses. In some implementations, a discriminator neural network 216 is also trained to facilitate adversarial losses 218 and, in some cases, additional reconstruction losses.

The training system 300 receives a set of training examples 116. Each training example 116 includes a respective input audio waveform 202 and a corresponding target audio waveform 204 that the neural networks are trained to reconstruct. That is, using the objective function 214, the target waveform 204 can be compared with a resulting output audio waveform 206 to evaluate performance of the neural networks. Specifically, the objective function 214 can include a reconstruction loss that measures an error between the target waveform 204 and the output waveform 206. In some cases, a point-wise reconstruction loss on the raw waveforms is implemented, for example, using a mean squared error between the waveforms.

However, this type of reconstruction loss may have limitations in certain cases, e.g., because two distinct waveforms can sound perceptually identical, while point-wise similar waveforms can sound very different. To alleviate this problem, the objective function 214 can utilize a multi-scale spectral reconstruction loss that measures an error between mel-spectrograms of the target waveform 204 and the output waveform 206. A spectrogram characterizes the frequency spectrum of an audio waveform over time, e.g., using a short-time Fourier transform (STFT). A mel-spectrogram is a spectrogram converted to mel-scale. Since humans generally do not perceive sound frequencies on a linear scale, the mel-scale can appropriately weigh frequency components to promote fidelity. For example, the reconstruction loss 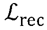 between the target waveform *x̃* and the output waveform *x̂* can include terms that measure an absolute error and a log error of mel-spectrograms, ${L}_{rec} = {\sum }_{s ∈ {2}^{6} , ⋯ {, 2}^{11}} {\sum }_{t} \left({\left‖{S}_{t}^{s}\left({x}^{˜}\right)-{S}_{t}^{s}\left(\hat{x}\right)\right‖}_{1}+{α}_{s}{\left‖log {S}_{t}^{s}\left({x}^{˜}\right)-log {S}_{t}^{s}\left(\hat{x}\right)\right‖}_{2}\right)$ where ∥··· ∥*ₙ* indicates the *Lⁿ*-norm. Although other reconstructions losses are possible, this form of 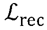 satisfies a strictly proper scoring rule which can be desirable for training purposes. Here, ${S}_{t}^{s}$ denotes the t-th frame (e.g., timeslice) of a 64-bin mel-spectrogram computed with window length equal to *s* and hop length equal to s/4. The α*ₛ* coefficient can be set to ${α}_{s} = \sqrt{s / 2}$ .

As mentioned previously, the set of training examples 116 can be selected to enable various modalities of the compression/decompression systems 100/200, such as general-purpose audio compression, speech-tailored compression, etc. For example, to train for general-purpose audio compression, the training examples 116 can include speech, music, and general audio waveforms. In other implementations, the training examples 116 may only include music waveforms to facilitate optimal music compression and playback.

In some cases, the target waveform 204 is identical to the input waveform 202, which can train the neural networks towards faithful and perceptually similar reconstructions. However, the target waveform 204 can also be modified with respect to the input waveform 202 to encourage more sophisticated functionalities, such as joint compression and enhancement. The nature of the enhancement can be determined by designing training examples 116 with certain qualities. For instance, the target waveform 204 can be a speech enhanced version of the input waveform 202, such that the neural networks improve audio dialogue upon reconstruction of waveforms. Altematively or in addition, the target waveform 204 can be a denoised version of the input waveform 202, which trains the networks to suppress background noise. In general, any desired audio enhancement can be enabled using this technique.

In further implementations, the encoder 102 and/or decoder 104 can be conditioned on data, usually included in the training examples 116, that defines whether the target waveform 204 is identical to the input waveform 202 or is an enhanced version of the waveform 202. For instance, the training examples 116 can include a conditioning signal that represents the two modes (enhancement enabled or disabled), such that the neural networks are trained to only enable enhancement when the signal is present. To implement this, the encoder 102 and/or decoder 104 can have a dedicated layer, such as a Feature-wise Linear Modulation (FilM) layer, to process the conditioning signal. After training, this technique can allow the audio compression/decompression systems 100/200 to flexibly control enhancement in real-time by feeding the conditioning signal through the network. Accordingly, the compression system 100 can implement this controllable enhancement to permit compression of acoustic scenes and natural sounds that would be otherwise removed by enhancement (e.g., denoising).

Returning now to the encoder neural network 102. The input waveform 202 is processed by the encoder 102 and encoded into a sequence of feature vectors 208. This process, that may involve numerous encoder network layers, can be collectively represented by an encoder function *ε_{θ}* that maps the input waveform x to the feature vectors y, such that y(x) *= ε_{θ}*(*x*)*.* The encoder function *ε_{θ}* is parametrized by encoder network parameters *θ* which can be updated using the objective function 214 to minimize losses during encoding.

The feature vectors 208 are then compressed by the RVQ 106 to generate coded CFVs 210 and corresponding QFVs 212. Note that the quantization process of the RVQ 106, which may involve numerous vector quantizers 108, can be collectively represented by a RVQ function 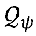 that maps the feature vectors y to the QFVs *ŷ*, such that *ŷ*(*x*) *=* 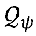 (*y*) *=* 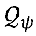 (*ε_{θ}*(*x*))*.* The RVQ function 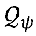 is parametrized by codebook parameters *ψ* which can be updated using the objective function 214 to minimize losses during quantization.

The training system 300 can minimize the quantization loss associated with the RVQ 106 by properly aligning the code vectors with the vector space of feature vectors 208. That is, the codebook parameters *ψ* can be updated by the training system 300 by backpropagating gradients of the objective function 214. For example, the codebooks 110 can be repeatedly updated during training using exponential moving averages of the feature vectors 208. The training system 300 can also improve usage of the codebooks 110 by running a k-means algorithm on a first set of training examples 116 and using the learned centroids as initialization for the following training examples 116. Alternatively or in addition, if a code vector has not been assigned to a feature vector 208 for numerous training examples 116, the training system 300 can replace it with a random feature vector 208 sampled during a current training example 116. For example, the training system 300 can track the exponential moving average of assignments to each code vector (with a decay factor of 0.99) and replace the code vectors of which this statistic falls below 2.

To adequately train the neural networks for variable (e.g., scalable) bit rates, the training system 300 can select a particular number *n_{q}* of vector quantizers 108 to be used for each training example 116, such that the number of quantizers 108 differs between training examples 116. For instance, the training system 300 can sample *n_{q}* uniformly at random in [1; *N_{q}*], for each training example 116, and only use the first *i =* 1···*n_{q}* quantizers 108 in the sequence. Consequently, the networks are trained to encode and decode audio waveforms for all target bitrates corresponding to the range *n_{q} =* 1···*N_{q}* and no architectural changes are necessary for the encoder 102 or decoder 104. After training, the audio compression and decompression systems 100/200 can select a particular number of quantizers *n_{q}* during compression and decompression which accommodates a desired bitrate.

Referring now to the decoder neural network 104. The QFVs 212 are processed by the decoder 104 and decoded into the output audio waveform 206. Analogous to the encoder 102, decoding may involve numerous decoder network layers, that can be collectively represented by a decoder function 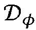 . The decoder function 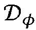 maps the input QFVs *ŷ* to the output waveform *x̂*, such that *x̂*(*x*) = 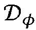 (*ŷ*) = 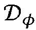 ( 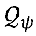 (*ε_{θ}*(*x*)))*.* In some implementations, the input waveform x and the output waveform *x̂* have the same sampling rate, but this need not be the case. The decoder function 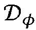 is parametrized by decoder network parameters *Φ* which can be updated using the objective function 214 to minimize losses during decoding.

Since the output waveform *x̂* generally depends on encoder network parameters *θ*, codebook parameters *ψ* and decoder network parameters *ϕ*, the objective function 214, which includes reconstruction losses between the output waveform 206 and the target waveform 204 of each training example 116, can be used to update these network parameters. Specifically, gradients of the objective function 214 can be computed to iteratively update the network parameters with backpropagation, e.g., using a gradient descent method. Generally, the network parameters are updated with the goal of optimizing the objective function 214.

In some implementations, the training system 300 exploits a discriminator neural network 216 to incorporate adversarial loss 218 into the objective function 214, and potentially additional reconstruction losses. The adversarial loss 218 can promote perceptual quality of waveforms reconstructed by the neural networks. In this case, the discriminator 216 is jointly trained by the training system 300 and contests with the encoder 102, decoder 104, and RVQ 106. That is, the discriminator 216 is trained to distinguish target waveforms 204 from output waveforms 206 while the encoder 102, decoder 104 and RVQ 106 are trained to fool the discriminator 216.

The discriminator 216 can implement this into the adversarial loss 218 by using a set of discriminator scores 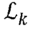 with *k* = {1,2, *..., K},* such that each score characterizes an estimated likelihood that the output waveform 206 is not generated as output from the decoder 104. For example, the discriminator 216 can receive the output waveform *x̂* from the decoder 104 and process the waveform using one or more neural network layers to generate logits 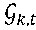 (*x̂*)*.* In this case 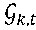 is a discriminator function that maps an input waveform to output logits. *k* indexes a particular discriminator output and *t* indexes a particular logit of the discriminator output. In some implementations, the discriminator 216 utilizes a fully convolutional neural network such that the number of logits is proportional to the length of the input waveform.

The discriminator 216 can use the logits to determine the respective discriminator scores 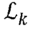 for each discriminator output *k.* For example, each score 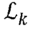 can be determined from the average over logits as, ${L}_{k} = {E}_{x} \left[\frac{1}{{T}_{k}}{\sum }_{t} max \left[0,1-{G}_{k , t}\left(\hat{x}\left(x\right)\right)\right]\right]$

Here, *Tₖ* is the total number of logits for the output *k* and *Eₓ* is the expected value over x. In some implementations, the adversarial loss 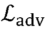 is an average over the discriminator scores 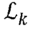 , ${L}_{adv} = \frac{1}{K} {\sum }_{k} {L}_{k}$

The adversarial loss 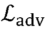 can be included in the objective function 214 to promote perceptual quality of reconstructed waveforms. Moreover, the discriminator 216 can be trained by the training system 300 to distinguish target waveforms *x̃* from output waveforms *x̂* by minimizing a discriminator loss function 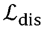 . In some implementations, 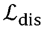 has the form, ${L}_{dis} = \frac{1}{K} {\sum }_{k} {E}_{x} \left[\frac{1}{{T}_{k}}{\sum }_{t} max \left[0,1-{G}_{k , t}\left({x}^{˜}\left(x\right)\right)\right]\right] + \frac{1}{K} {\sum }_{k} {E}_{x} \left[\frac{1}{{T}_{k}}{\sum }_{t} max \left[0,1+{G}_{k , t}\left(\hat{x}\left(x\right)\right)\right]\right]$

Note, target waveforms *x̃*(*x*) generally depend on input waveforms x in that they can be identical to the input waveform *x̃*(*x*) = x or an enhanced version. By training the discriminator 216 to efficiently classify target waveforms 204 from output waveforms 206 with respect to 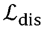 , the encoder 102, decoder 104, and RVQ 106 leam to fool the discriminator by minimizing 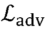 .

In some implementations, the discriminator 216 exploits different versions of the waveforms to determine the discriminator scores 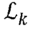 *.* For example, besides the original waveforms, the discriminator 216 can also use down-sampled versions of the waveforms (e.g., 2-times down-sampled, 4-times down-sampled, etc.) or Fourier-transformed versions of the waveforms (e.g., STFT, Hartley transform, etc.) which adds diversity to the adversarial loss 218. As a particular implementation using four discriminator scores, the 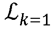 score can correspond to a STFT waveform, while discriminator scores 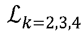 can correspond to an original waveform, a 2-times down-sampled waveform and a 4-times down-sampled waveform.

In further implementations, the discriminator 216 introduces a reconstruction loss in the form of a "feature loss". Specifically, the feature loss 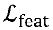 measures an error between the discriminator's internal layer outputs for the target audio waveform 204 and those for the output audio waveform 206. For example, the feature loss 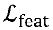 can be expressed as the absolute difference between discriminator outputs ${G}_{k , t}^{\left(l\right)}$ for the target waveform *x̃* and output waveform *x̂* for each layer *l* ∈ {1,2, ... , *L}* as, ${L}_{feat} = {E}_{x} \left[\frac{1}{KL}{\sum }_{k , l} \frac{1}{{T}_{k , l}}{\sum }_{t} \left|{G}_{k , t}^{\left(l\right)}\left({x}^{˜}\left(x\right)\right)-{G}_{k , t}^{\left(l\right)}\left(\hat{x}\left(x\right)\right)\right|\right]$

The feature loss can be a useful tool to promote increased fidelity between the output waveform 206 and the target waveform 204. Taking into account all the aforementioned loss terms, the objective function 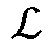 can control tradeoffs between reconstruction losses, adversarial losses, as well as feature losses, $L = {λ}_{r ec} {L}_{rec} + {λ}_{adv} {L}_{adv} + {λ}_{feat} {L}_{feat}$

By weighting appropriate loss terms with weight factors *λ*_{rec}, *λ*_{adv} and λ_{feat}, the objective function 214 can emphasize certain properties, such as faithful reconstructions, fidelity, perceptual quality, etc. In some implementations, the weight factors are set to *λ*_{rec} = *λ*_{adv} = 1 and λ_{feat} = 100.

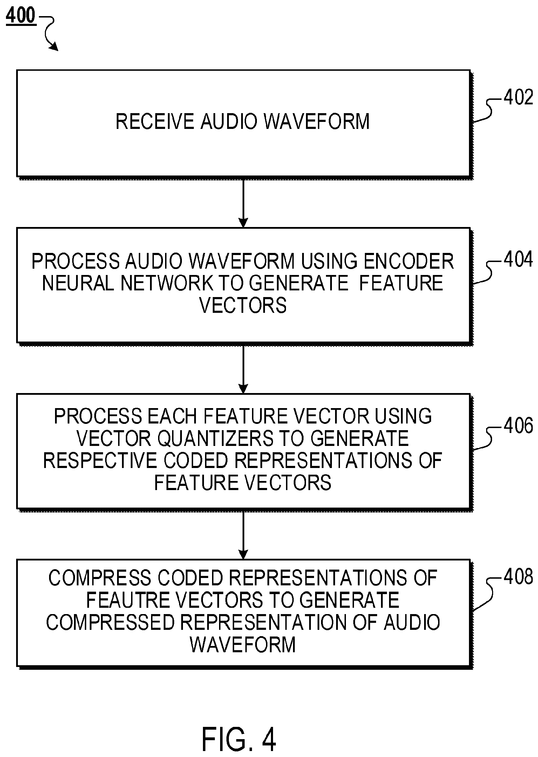

FIG. 4 is a flow diagram of an example process 400 for compressing an audio waveform. For convenience, the process 400 will be described as being performed by a system of one or more computers located in one or more locations. For example, an audio compression system, e.g., the audio compression system 100 of FIG. 1, appropriately programmed in accordance with this specification, can perform the process 400.

The system receives an audio waveform (402). The audio waveform includes a respective audio sample at each of a plurality of time steps. In some cases, the time steps may correspond to a particular sampling rate.

The system processes the audio waveform using an encoder neural network to generate feature vectors (404) representing the audio waveform.

The system processes each feature vector using a plurality of vector quantizers to generate respective coded representations of the feature vectors (406), where each vector quantizer is associated with a respective codebook of code vectors. Each coded representation of a feature vector identifies a plurality of code vectors, including a code vector from the codebook of each vector quantizer, which define a respective quantized representation of the feature vector. In some implementations, the respective quantized representation of the feature vector is defined by a sum of the plurality of code vectors.

The system compresses the coded representations of the feature vectors to generate a compressed representation of the audio waveform (408). In some implementations, the system compresses the coded representations of the feature vectors using entropy encoding.

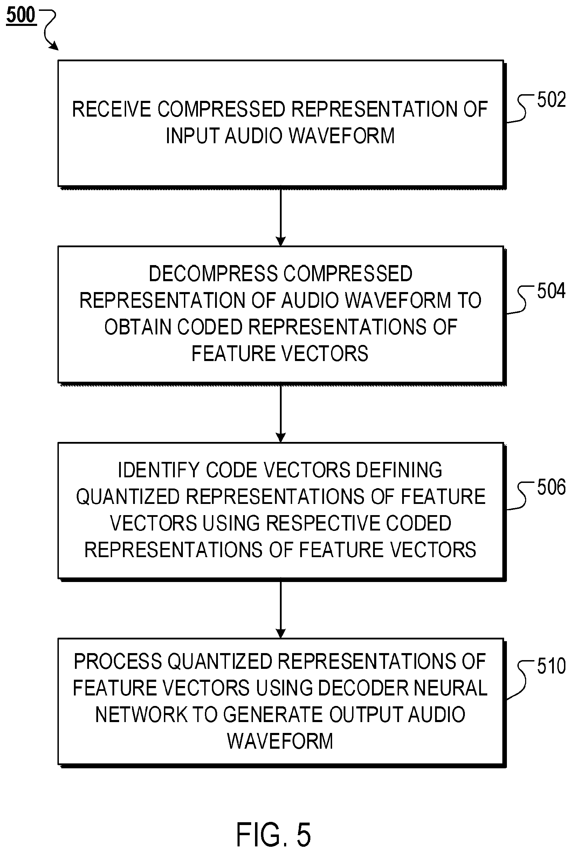

FIG. 5 is a flow diagram of an example process 500 for decompressing a compressed audio waveform. For convenience, the process 500 will be described as being performed by a system of one or more computers located in one or more locations. For example, an audio decompression system, e.g., the audio decompression system 200 of FIG. 2, appropriately programmed in accordance with this specification, can perform the process 500.

The system receives a compressed representation of an input audio waveform (502).

The system decompresses the compressed representation of the audio waveform to obtain coded representations of feature vectors representing the input audio waveform (504). In some implementations, the system decompresses the compressed representation of the input audio waveform using entropy decoding.

The system identifies, for each coded representation of the feature vectors, a plurality of code vectors, including a code vector from the codebook of each vector quantizer, that define a respective quantized representation of the feature vector (506). In some implementations, the respective quantized representation of the feature vector is defined by a sum of the plurality of code vectors.

The system processes the quantized representations of the feature vectors using a decoder neural network to generate an output audio waveform (510). The output audio waveform may include a respective audio sample at each of a plurality of time steps. In some cases, the time steps may correspond to a particular sampling rate.

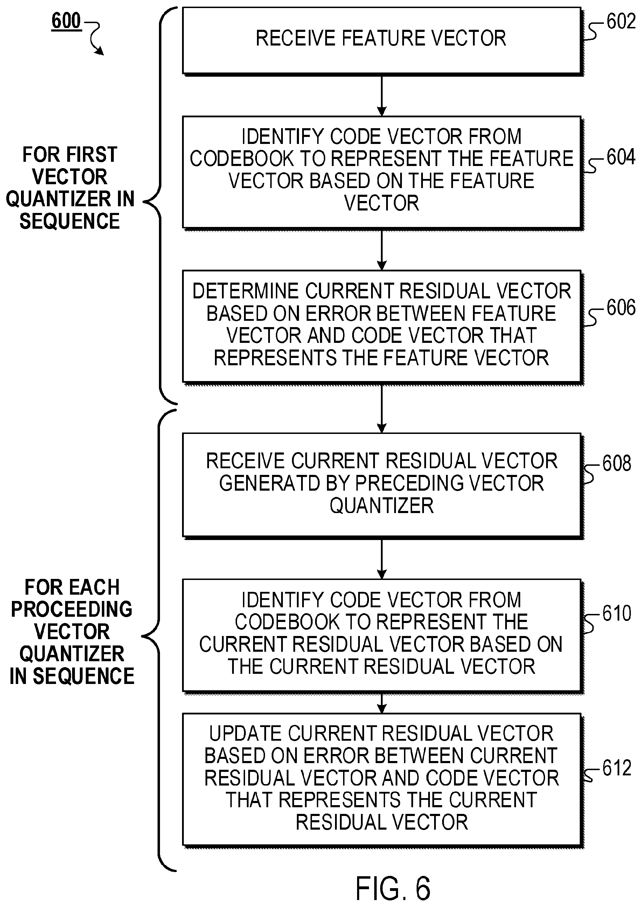

FIG. 6 is a flow diagram of an example process 600 for generating quantized representations of feature vectors using a residual vector quantizer. For convenience, the process 600 will be described as being performed by a system of one or more computers located in one or more locations.

The system receives a feature vector at a first vector quantizer in a sequence of vector quantizers (602).

The system identifies, based on the feature vector, a code vector from a codebook of the first vector quantizer in the sequence to represent the feature vector (604). For example, a distance metric (e.g., error) can be computed between the feature vector and each code vector in the codebook. The code vector with the smallest distance metric can be selected to represent the feature vector.

The system determines a current residual vector based on an error between the feature vector and the code vector that represents the feature vector (606). For example, the residual vector can be the difference between the feature vector and the code vector that represents the feature vector. A codeword corresponding to the code vector that represents the feature vector can be stored in a coded representation of the feature vector.

The system receives the current residual vector generated by a preceding vector quantizer in the sequence at a next vector quantizer in the sequence (608).

The system identifies, based on the current residual vector, a code vector from a codebook of the next vector quantizer in the sequence to represent the current residual vector (610). For example, a distance metric (e.g., error) can be computed between the current residual vector and each code vector in the codebook. The code vector with the smallest distance metric can be selected to represent the current residual vector. A codeword corresponding to the code vector that represents the current residual vector can be stored in the coded representation of the feature vector.

The system updates the current residual vector based on an error between the current residual vector and the code vector that represents the current residual vector (612). For example, the current residual vector can be updated by subtracting the code vector that represents the current residual vector from the current residual vector.

Steps 606-612 can be repeated for each remaining vector quantizer in the sequence. The final coded representation of the feature vector contains the codeword of each code vector selected from its respective codebook during the process 600. A quantized representation of the feature vector corresponds to the summation of all code vectors specified by the codewords of the coded representation of the feature vector. In some implementations, the codebooks of the vector quantizers in the sequence include an equal number of code vectors such that each codebook is allocated the same space in memory.

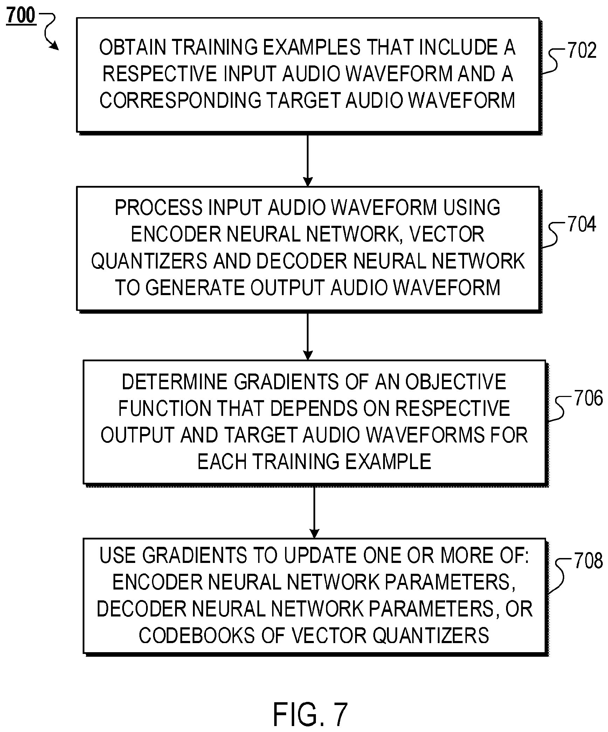

FIG. 7 is a flow diagram of an example process 700 for jointly training an encoder neural network, a decoder neural network and a residual vector quantizer. For convenience, the process 700 will be described as being performed by a system of one or more computers located in one or more locations. For example, a training system, e.g., the training system 300 of FIG. 3, appropriately programmed in accordance with this specification, can perform the process 700.

The system obtains training examples that include a respective input audio waveform and a corresponding target audio waveform (702). In some implementations, the target audio waveform of one or more of the training examples can be an enhanced version of the input audio waveform, such as a denoised version of the input audio waveform. The target audio waveform of one or more of the training examples can also be the same as the input audio waveform. Alternatively or in addition, the input audio waveform can be a speech or music waveform.

The system processes the input audio waveform for each training example using an encoder neural network, a plurality of vector quantizers, and a decoder neural network to generate a respective output audio waveform (704), where each vector quantizer is associated with a respective codebook. In some implementations, the encoder and/or decoder neural networks are conditioned on data that defines where the corresponding target audio waveform is the same as the input audio waveform or an enhanced version of the input audio waveform.

The system determines gradients of an objective function, e.g., using backpropagation, that depends on the respective output and target audio waveforms for each training example (706).

The system uses the gradients of the objective function to update one or more of: a set of encoder network parameters, a set of decoder network parameters, or the codebooks of the plurality of vector quantizers (708). For example, the parameters can be updated using an update rule of any appropriate gradient descent optimization technique, e.g., RMSprop, Adam, etc.

FIGS. 8A and 8B show an example of a fully convolutional neural network architecture for the encoder 102 and decoder 104 neural networks. C represents the number of channels and D is the dimensionality of the feature vectors 208. The architecture in FIGS. 8A and 8B is based on the *SoundStream* model developed by N. Zeghidour, A. Luebs, A. Omran, J. Skoglund and M. Tagliasacchi, "SoundStream: An End-to-End Neural Audio Codec," in IEEE/ACM Transactions on Audio, Speech, and Language Processing, vol. 30, pp. 495-507, 2022. This model is an adaptation of the *SEANet* encoder-decoder network, but without skip connections, designed by Y. Li, M. Tagliasacchi, O. Rybakov, V. Ungureanu and D. Roblek, "Real-Time Speech Frequency Bandwidth Extension," ICASSP 2021 - 2021 IEEE International Conference on Acoustics, Speech and Signal Processing (ICASSP), 2021, pp. 691-695.

The encoder 102 includes a Conv1D layer 802 followed by four EncoderBlocks 804. Each of the blocks includes three ResidualUnits 812, containing dilated convolutions with dilation rates of 1, 3, and 9, respectively, followed by a down-sampling layer in the form of a strided convolution. Intemal convolutional layers of EncoderBlocks 804 and ResidualUnits 812 are shown in FIG. 8B. The number of channels is doubled whenever down-sampling. A final Conv1D layer 802 with a kernel of length 3 and a stride of 1 is used to set the dimensionality of the feature vectors 208 to D. A FiLM conditioning layer 806 can also be implemented to process a conditioning signal for use in joint compression and enhancement. The FiLM layer 806 carries out a feature-wise affine transformation on the neural network's feature vectors 208, conditioned on the conditioning signal.

In this case, the decoder 104 effectively mirrors the encoder 102. The DecoderBlocks 810 include a transposed Conv1D layer 814 for up-sampling followed by three ResidualUnits 812. Internal convolutional layers of DecoderBlocks 810 and ResidualUnits 812 are shown in FIG. 8B. The decoder 104 uses the same strides as the encoder 102, but in reverse order, to reconstruct a waveform with the same resolution as the input waveform. The number of channels is halved whenever up-sampling. A final Conv1D layer 802 with one filter, a kernel of size 7 and stride 1 projects the feature vectors 208 back to the waveform 112. A FiLM conditioning layer 806 can also be implemented to process the conditioning signal for joint decompression and enhancement. In some implementations, both the encoder 102 and decoder 104 perform audio enhancement, while in other implementations only one of the encoder 102 or decoder 104 is responsible.

This specification uses the term "configured" in connection with systems and computer program components. For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non-transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially-generated propagated signal, e.g., a machine-generated electrical, optical, or electromagnetic signal, that is generated to encode information for transmission to suitable receiver apparatus for execution by a data processing apparatus.

The term "data processing apparatus" refers to data processing hardware and encompasses **all** kinds of apparatus, devices, and machines for processing data, including by way of example a programmable processor, a computer, or multiple processors or computers. The apparatus can also be, or further include, special purpose logic circuitry, e.g., an FPGA (field programmable gate array) or an ASIC (application-specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program, which may also be referred to or described as a program, software, a software application, an app, a module, a software module, a script, or code, can be written in any form of programming language, including compiled or interpreted languages, or declarative or procedural languages; and it can be deployed in any form, including as a stand-alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub-programs, or portions of code. A computer program can be deployed to be executed on one computer or on multiple computers that are located at one site or distributed across multiple sites and interconnected by a data communication network.

**In** this specification the term "engine" is used broadly to refer to a software-based system, subsystem, or process that is programmed to perform one or more specific functions. Generally, an engine will be implemented as one or more software modules or components, installed on one or more computers in one or more locations. In some cases, one or more computers will be dedicated to a particular engine; in other cases, multiple engines can be installed and running on the same computer or computers.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read-only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer-readable media suitable for storing computer program instructions and data include all forms of non-volatile memory, media and memory devices, including by way of example semiconductor memory devices, e.g., EPROM, EEPROM, and flash memory devices; magnetic disks, e.g., intemal hard disks or removable disks; magneto-optical disks; and CD-ROM and DVD-ROM disks.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser. Also, a computer can interact with a user by sending text messages or other forms of message to a personal device, e.g., a smartphone that is running a messaging application, and receiving responsive messages from the user in return.

Data processing apparatus for implementing machine learning models can also include, for example, special-purpose hardware accelerator units for processing common and compute-intensive parts of machine leaming training or production, i.e., inference, workloads.

Machine learning models can be implemented and deployed using a machine learning framework, e.g., a TensorFlow framework.

Embodiments of the subject matter described in this specification can be implemented in a computing system that includes a back-end component, e.g., as a data server, or that includes a middleware component, e.g., an application server, or that includes a front-end component, e.g., a client computer having a graphical user interface, a web browser, or an app through which a user can interact with an implementation of the subject matter described in this specification, or any combination of one or more such back-end, middleware, or front-end components. The components of the system can be interconnected by any form or medium of digital data communication, e.g., a communication network. Examples of communication networks include a local area network (LAN) and a wide area network (WAN), e.g., the Internet.

The computing system can include clients and servers. A client and server are generally remote from each other and typically interact through a communication network. The relationship of client and server arises by virtue of computer programs running on the respective computers and having a client-server relationship to each other. In some embodiments, a server transmits data, e.g., an HTML page, to a user device, e.g., for purposes of displaying data to and receiving user input from a user interacting with the device, which acts as a client. Data generated at the user device, e.g., a result of the user interaction, can be received at the server from the device.

While this specification contains many specific implementation details, these should not be construed as limitations on the scope of any invention or on the scope of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination.

In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

## Claims

1. A method performed by one or more computers, the method comprising:
receiving an audio waveform (112) that comprises a respective audio sample for each of a plurality of time steps;
processing the audio waveform using an encoder neural network (102) to generate a plurality of feature vectors (208) representing the audio waveform;
generating a respective coded representation of each of the plurality of feature vectors using a sequence of vector quantizers (108) that are each associated with a respective codebook (110) of code vectors,
wherein the respective coded representation of each feature vector identifies a plurality of code vectors, including a respective code vector from the respective codebook of each vector quantizer, that define a quantized representation of the feature vector; and
generating a compressed representation of the audio waveform (114) by compressing the respective coded representation of each of the plurality of feature vectors,
wherein the encoder neural network and the codebooks of the vector quantizers have been jointly trained along with a decoder neural network configured to:
receive the respective quantized representation of each of the plurality of feature vectors representing an audio waveform that have been generated using the encoder neural network and the sequence of vector quantizers; and
process the quantized representations of the feature vectors to generate an output audio waveform, and
wherein for each of the plurality of feature vectors, generating the respective coded representation of the feature vector using the sequence of vector quantizers comprises:
for a first vector quantizer in the sequence of vector quantizers:
receiving the feature vector;
identifying, based on the feature vector, a respective code vector from the codebook of the vector quantizer to represent the feature vector; and
determining a current residual vector based on an error between: (i) the feature vector, and (ii) the learned code vector that represents the feature vector;
wherein the coded representation of the feature vector identifies the code vector that represents the feature vector, and
for each vector quantizer after the first vector quantizer in the sequence of vector quantizers:
receiving a current residual vector generated by a preceding vector quantizer in the sequence of vector quantizers;
identifying, based on the current residual vector, a respective code vector from the codebook of the vector quantizer to represent the current residual vector; and
if the vector quantizer is not a last vector quantizer in the sequence of vector quantizers:
updating the current residual vector based on an error between: (i) the current residual vector, and (ii) the code vector that represents the current residual vector;
wherein the coded representation of the feature vector identifies the code vector that represents the current residual vector.

2. The method of any preceding claim, wherein generating the compressed representation of the audio waveform comprises:
entropy encoding the respective coded representation of each of the plurality of feature vectors.

3. The method of any preceding claim, wherein the respective quantized representation of each feature vector is defined by a sum of the plurality of code vectors identified by the coded representation of the feature vector.

4. The method of any preceding claim, wherein the codebooks of the plurality of vector quantizers all include an equal number of code vectors.

5. The method of any preceding claim, wherein the training comprised:
obtaining a plurality of training examples that each include: (i) a respective input audio waveform, and (ii) a corresponding target audio waveform;
processing the respective input audio waveform from each training example using the encoder neural network, a plurality of vector quantizers from the sequence of vector quantizers, and the decoder neural network to generate an output audio waveform that is an estimate of the corresponding target audio waveform;
determining gradients of an objective function that depends on the respective output and target waveforms for each training example; and
using the gradients of the objective function to update one or more of: a set of encoder neural network parameters, a set of decoder neural network parameters, or the codebooks of the plurality of vector quantizers.

6. The method of claim 5, wherein the objective function comprises a reconstruction loss that, for each training example, measures an error between: (i) the output audio waveform, and (ii) the corresponding target audio waveform.

7. The method of claim 6, wherein for each training example, the reconstruction loss measures a multi-scale spectral error between: (i) the output audio waveform, and (ii) the corresponding target audio waveform.

8. The method of any preceding claim, wherein the audio waveform is a speech waveform or a music waveform.

9. The method of any preceding claim, further comprising transmitting the compressed representation of the audio waveform across a network.

10. A system comprising:
one or more computers; and
one or more storage devices communicatively coupled to the one or more computers, wherein the one or more storage devices store instructions that, when executed by the one or more computers, cause the one or more computers to perform operations of the respective method of any one of claims 1-9.

11. One or more non-transitory computer storage media storing instructions that when executed by one or more computers cause the one or more computers to perform operations of the respective method of any one of claims 1-9.

## Patentansprüche

1. Verfahren, das durch einen oder mehrere Computer durchgeführt wird, wobei das Verfahren Folgendes umfasst:
Empfangen einer Audiowellenform (112), die einen jeweiligen Audioabtastwert für jeden einer Mehrzahl von Zeitschritten umfasst;
Verarbeiten der Audiowellenform unter Verwendung eines neuronalen Encoder-Netzwerks (102), um eine Mehrzahl von Merkmalsvektoren (208) zu erzeugen, die die Audiowellenform repräsentieren;
Erzeugen einer jeweiligen codierten Darstellung jedes der Mehrzahl von Merkmalsvektoren unter Verwendung einer Folge von Vektorquantisierern (108), die jeweils einem jeweiligen Codebuch (110) von Codevektoren zugeordnet sind,
wobei die jeweilige codierte Darstellung jedes Merkmalsvektors eine Mehrzahl von Codevektoren identifiziert, einschließlich eines jeweiligen Codevektors aus dem jeweiligen Codebuch jedes Vektorquantisierers, die eine quantisierte Darstellung des Merkmalsvektors definieren; und
Erzeugen einer komprimierten Darstellung der Audiowellenform (114) durch Komprimieren der jeweiligen codierten Darstellung jedes der Mehrzahl von Merkmalsvektoren,
wobei das neuronale Encoder-Netzwerk und die Codebücher der Vektorquantisierer gemeinsam mit einem neuronalen Decoder-Netzwerk trainiert wurden, das dazu konfiguriert ist:
die jeweilige quantisierte Darstellung jedes der Mehrzahl von Merkmalsvektoren, die eine Audiowellenform repräsentieren, zu empfangen, die unter Verwendung des neuronalen Encoder-Netzwerks und der Folge von Vektorquantisierern erzeugt wurden; und
die quantisierten Darstellungen der Merkmalsvektoren zu verarbeiten, um eine Ausgangs-Audiowellenform zu erzeugen, und
wobei für jeden der Mehrzahl von Merkmalsvektoren das Erzeugen der jeweiligen codierten Darstellung des Merkmalsvektors unter Verwendung der Folge von Vektorquantisierern Folgendes umfasst: für einen ersten Vektorquantisierer in der Folge von Vektorquantisierern:
Empfangen des Merkmalsvektors;
Identifizieren, auf der Grundlage des Merkmalsvektors, eines jeweiligen Codevektors aus dem Codebuch des Vektorquantisierers, um den Merkmalsvektor zu repräsentieren; und
Bestimmen eines aktuellen Residuenvektors auf der Grundlage eines Fehlers zwischen: (i) dem Merkmalsvektor und (ii) dem gelernten Codevektor, der den Merkmalsvektor repräsentiert;
wobei die codierte Darstellung des Merkmalsvektors den Codevektor identifiziert, der den Merkmalsvektor repräsentiert, und
für jeden Vektorquantisierer nach dem ersten Vektorquantisierer in der Folge von Vektorquantisierern:
Empfangen eines aktuellen Residuenvektors, der von einem vorhergehenden Vektorquantisierer in der Folge von Vektorquantisierern erzeugt wurde;
Identifizieren, auf der Grundlage des aktuellen Residuenvektors, eines jeweiligen Codevektors aus dem Codebuch des Vektorquantisierers, um den aktuellen Residuenvektor zu repräsentieren; und
wenn der Vektorquantisierer nicht ein letzter Vektorquantisierer in der Folge von Vektorquantisierern ist:
Aktualisieren des aktuellen Residuenvektors auf der Grundlage eines Fehlers zwischen: (i) dem aktuellen Residuenvektor und (ii) dem Codevektor, der den aktuellen Residuenvektor repräsentiert;
wobei die codierte Darstellung des Merkmalsvektors den Codevektor identifiziert, der den aktuellen Residuenvektor repräsentiert.

2. Verfahren nach einem vorhergehenden Anspruch, wobei das Erzeugen der komprimierten Darstellung der Audiowellenform Folgendes umfasst:
Entropiecodieren der jeweiligen codierten Darstellung jedes der Mehrzahl von Merkmalsvektoren.

3. Verfahren nach einem vorhergehenden Anspruch, wobei die jeweilige quantisierte Darstellung jedes Merkmalsvektors durch eine Summe der Mehrzahl von Codevektoren definiert ist, die durch die codierte Darstellung des Merkmalsvektors identifiziert werden.

4. Verfahren nach einem vorhergehenden Anspruch, wobei die Codebücher der Mehrzahl von Vektorquantisierern alle eine gleiche Anzahl von Codevektoren beinhalten.

5. Verfahren nach einem vorhergehenden Anspruch, wobei das Trainieren umfasste:
Erhalten einer Mehrzahl von Trainingsbeispielen, die jeweils Folgendes beinhalten: (i) eine jeweilige Eingangs-Audiowellenform und (ii) eine entsprechende Ziel-Audiowellenform;
Verarbeiten der jeweiligen Eingangs-Audiowellenform aus jedem Trainingsbeispiel unter Verwendung des neuronalen Encoder-Netzwerks, einer Mehrzahl von Vektorquantisierern aus der Folge von Vektorquantisierern und des neuronalen Decoder-Netzwerks, um eine Ausgangs-Audiowellenform zu erzeugen, die eine Schätzung der entsprechenden Ziel-Audiowellenform ist;
Bestimmen von Gradienten einer Zielfunktion, die von den jeweiligen Ausgangs- und Zielwellenformen für jedes Trainingsbeispiel abhängt; und
Verwenden der Gradienten der Zielfunktion, um eines oder mehrere von Folgendem zu aktualisieren: einen Satz von Parametern des neuronalen Encoder-Netzwerks, einen Satz von Parametern des neuronalen Decoder-Netzwerks oder die Codebücher der Mehrzahl von Vektorquantisierern.

6. Verfahren nach Anspruch 5, wobei die Zielfunktion einen Rekonstruktionsverlust umfasst, der für jedes Trainingsbeispiel einen Fehler zwischen: (i) der Ausgangs-Audiowellenform und (ii) der entsprechenden Ziel-Audiowellenform misst.

7. Verfahren nach Anspruch 6, wobei für jedes Trainingsbeispiel der Rekonstruktionsverlust einen mehrskaligen spektralen Fehler zwischen: (i) der Ausgangs-Audiowellenform und (ii) der entsprechenden Ziel-Audiowellenform misst.

8. Verfahren nach einem vorhergehenden Anspruch, wobei die Audiowellenform eine Sprachwellenform oder eine Musikwellenform ist.

9. Verfahren nach einem vorhergehenden Anspruch, ferner umfassend Übertragen der komprimierten Darstellung der Audiowellenform über ein Netzwerk.

10. System, umfassend:
einen oder mehrere Computer; und
eine oder mehrere Speichervorrichtungen, die kommunikativ mit dem einen oder den mehreren Computern gekoppelt sind, wobei die eine oder die mehreren Speichervorrichtungen Anweisungen speichern, die bei Ausführung durch den einen oder die mehreren Computer den einen oder die mehreren Computer veranlassen, Vorgänge des jeweiligen Verfahrens nach einem der Ansprüche 1-9 durchzuführen.

11. Ein oder mehrere nichtflüchtige Computerspeichermedien, die Anweisungen speichern, die bei Ausführung durch den einen oder die mehreren Computer den einen oder die mehreren Computer veranlassen, Vorgänge des jeweiligen Verfahrens nach einem der Ansprüche 1-9 durchzuführen.

## Revendications

1. Procédé réalisé par un ou plusieurs ordinateurs, le procédé comprenant :
la réception d'une forme d'onde audio (112) qui comprend un échantillon audio respectif pour chaque pas temporel d'une pluralité de pas temporels ;
le traitement de la forme d'onde audio à l'aide d'un réseau neuronal d'encodeur (102) pour générer une pluralité de vecteurs de caractéristiques (208) représentant la forme d'onde audio ;
la génération d'une représentation codée respective de chacun de la pluralité de vecteurs de caractéristiques à l'aide d'une séquence de quantificateurs vectoriels (108) qui sont chacun associés à un livre de codes respectif (110) de vecteurs de code,
dans lequel la représentation codée respective de chaque vecteur de caractéristiques identifie une pluralité de vecteurs de code, comportant un vecteur de code respectif provenant du livre de codes respectif de chaque quantificateur vectoriel, qui définissent une représentation quantifiée du vecteur de caractéristiques ; et
la génération d'une représentation compressée de la forme d'onde audio (114) en compressant la représentation codée respective de chacun de la pluralité de vecteurs de caractéristiques,
dans lequel le réseau neuronal d'encodeur et les livres de codes des quantificateurs vectoriels ont été entraînés conjointement avec un réseau neuronal de décodeur configuré pour :
recevoir la représentation quantifiée respective de chacun de la pluralité de vecteurs de caractéristiques représentant une forme d'onde audio qui ont été générés à l'aide du réseau neuronal d'encodeur et de la séquence de quantificateurs vectoriels ; et
traiter les représentations quantifiées des vecteurs de caractéristiques pour générer une forme d'onde audio de sortie, et
dans lequel, pour chacun de la pluralité de vecteurs de caractéristiques, la génération de la représentation codée respective du vecteur de caractéristiques à l'aide de la séquence de quantificateurs vectoriels comprend :
pour un premier quantificateur vectoriel dans la séquence de quantificateurs vectoriels :
la réception du vecteur de caractéristiques ;
l'identification, sur la base du vecteur de caractéristiques, d'un vecteur de code respectif provenant du livre de codes du quantificateur vectoriel pour représenter le vecteur de caractéristiques ; et
la détermination d'un vecteur résiduel actuel sur la base d'une erreur entre : (i) le vecteur de caractéristiques et (ii) le vecteur de code appris qui représente le vecteur de caractéristiques ;
dans lequel la représentation codée du vecteur de caractéristiques identifie le vecteur de code qui représente le vecteur de caractéristiques, et
pour chaque quantificateur vectoriel après le premier quantificateur vectoriel dans la séquence de quantificateurs vectoriels :
la réception d'un vecteur résiduel actuel généré par un quantificateur vectoriel précédent dans la séquence de quantificateurs vectoriels ;
l'identification, sur la base du vecteur résiduel actuel, d'un vecteur de code respectif provenant du livre de codes du quantificateur vectoriel pour représenter le vecteur résiduel actuel ; et
si le quantificateur vectoriel n'est pas un dernier quantificateur vectoriel dans la séquence de quantificateurs vectoriels :
la mise à jour du vecteur résiduel actuel sur la base d'une erreur entre : (i) le vecteur résiduel actuel et (ii) le vecteur de code qui représente le vecteur résiduel actuel ;
dans lequel la représentation codée du vecteur de caractéristiques identifie le vecteur de code qui représente le vecteur résiduel actuel.

2. Procédé selon une quelconque revendication précédente, dans lequel la génération de la représentation compressée de la forme d'onde audio comprend :
l'encodage entropique de la représentation codée respective de chacun de la pluralité de vecteurs de caractéristiques.

3. Procédé selon une quelconque revendication précédente, dans lequel la représentation quantifiée respective de chaque vecteur de caractéristiques est définie par une somme de la pluralité de vecteurs de code identifiés par la représentation codée du vecteur de caractéristiques.

4. Procédé selon une quelconque revendication précédente, dans lequel les livres de codes de la pluralité de quantificateurs vectoriels comportent tous un nombre égal de vecteurs de code.

5. Procédé selon une quelconque revendication précédente, dans lequel l'entraînement comprend :
l'obtention d'une pluralité d'exemples d'entraînement qui comportent chacun : (i) une forme d'onde audio d'entrée respective et (ii) une forme d'onde audio cible correspondante ;
le traitement de la forme d'onde audio d'entrée respective de chaque exemple d'entraînement à l'aide du réseau neuronal d'encodeur, d'une pluralité de quantificateurs vectoriels de la séquence de quantificateurs vectoriels et du réseau neuronal de décodeur pour générer une forme d'onde audio de sortie qui est une estimation de la forme d'onde audio cible correspondante ;
la détermination de gradients d'une fonction objectif qui dépend des formes d'onde de sortie et cible respectives pour chaque exemple d'entraînement ; et
l'utilisation des gradients de la fonction objectif pour mettre à jour un ou plusieurs des éléments suivants : un ensemble de paramètres de réseau neuronal d'encodeur, un ensemble de paramètres de réseau neuronal de décodeur ou les livres de codes de la pluralité de quantificateurs vectoriels.

6. Procédé selon la revendication 5, dans lequel la fonction objectif comprend une perte de reconstruction qui, pour chaque exemple d'entraînement, mesure une erreur entre : (i) la forme d'onde audio de sortie et (ii) la forme d'onde audio cible correspondante.

7. Procédé selon la revendication 6, dans lequel pour chaque exemple d'entraînement, la perte de reconstruction mesure une erreur spectrale multi-échelle entre : (i) la forme d'onde audio de sortie et (ii) la forme d'onde audio cible correspondante.

8. Procédé selon une quelconque revendication précédente, dans lequel la forme d'onde audio est une forme d'onde vocale ou une forme d'onde musicale.

9. Procédé selon une quelconque revendication précédente, comprenant en outre la transmission de la représentation compressée de la forme d'onde audio sur un réseau.

10. Système comprenant :
un ou plusieurs ordinateurs ; et
un ou plusieurs dispositifs de stockage couplés en communication aux un ou plusieurs ordinateurs, dans lequel les un ou plusieurs dispositifs de stockage stockent des instructions qui, lorsqu'elles sont exécutées par les un ou plusieurs ordinateurs, amènent les un ou plusieurs ordinateurs à réaliser des opérations du procédé respectif selon l'une quelconque des revendications 1 à 9.

11. Un ou plusieurs supports de stockage informatique non transitoires stockant des instructions qui, lorsqu'elles sont exécutées par un ou plusieurs ordinateurs, amènent les un ou plusieurs ordinateurs à réaliser des opérations du procédé respectif selon l'une quelconque des revendications 1 à 9.
